# EUROPÄISCHE PATENTSCHRIFT

(11) **EP 0 697 765 B1**
(45) Veröffentlichungstag und Bekanntmachung des Hinweises auf die Patenterteilung: **28.02.2001**
(21) Anmeldenummer: 95111267.1
(22) Anmeldetag: 18.07.1995
(51) Int. Cl.: H03D 7/14, H03C 1/54

(54) **Schaltung für FSK**
Circuit for phase shift keying
Circuit de modulation par déplacement de phase

(30) Priorität: 18.07.1994 DE 4425336
(43) Veröffentlichungstag der Anmeldung: 21.02.1996
(73) Patentinhaber: Infineon Technologies AG, 81541 München (DE)
(72) Erfinder: Sehrig, Peter, Ing. grad., D-82343 Pöcking (DE); Heinen, Stefan, Dr. Ing., D-47802 Kefeld (DE); Fenk, Josef, Dipl.-Ing., D-85386 Eching (DE)
(74) Vertreter: Zedlitz, Peter, Dipl.-Inf.

(56) Entgegenhaltungen:
- EP-A- 0 252 320
- EP-A- 0 321 701
- US-A- 4 334 198
- PATENT ABSTRACTS OF JAPAN vol. 11, no. 117 (E-498) [2564] , 11.April 1987 & JP 61 264904 A (MATSUSHITA ELECTRIC INDUSTRIAL CO., LTD), 22.November 1986,
- PROCEEDINGS OF THE BIPOLAR/BICMOS CIRCUITS AND TECHNOLOGY MEETING, MINNEAPOLIS, OCT. 5 - 6, 1992, 5.Oktober 1992, INSTITUTE OF ELECTRICAL AND ELECTRONICS ENGINEERS, Seiten 55-58, XP000340147 KWAN K W ET AL: "A BIPOLAR IF DEVICE FOR GSM MOBILE TELEPHONE"

## Beschreibung

Die Erfindung betrifft eine Schaltungsanordnung mit einer zwei Ausgangsanschlüsse aufweisenden Differenzverstärkerstufe und einer nachgeschalteten DC-entkoppelten Ausgangsstufe mit zwei Eingangszweigen gemäß den Merkmalen des Oberbegriffs des Patentanspruchs 1.

Eine solche Schaltungsanordnung ist in der Literaturstelle Patent Abstracts of Japan, Vol. 11, No. 117 (E-498) [2564], JP 61-264904 A gezeigt. Desweiteren ist eine Schaltungsanordnung mit einer zwei Ausgangsanschlüsse aufweisenden Differenzverstärkerstufe und einer nachgeschalteten DC-entkoppelten Ausgangsstufe mit zwei Eingangszweigen aus dem Buch R. Mäusl: Digitale Modulationsverfahren, 2. Auflage, Hüthig-Verlag, 1988, Seite 189 bekannt. Die Schaltungsanordnung wird bei der digitalen Modulation oder Demodulation eines Sinusträgers nach dem Prinzip der Phasenumtastung als Mischerschaltung eingesetzt und als Gilbertzelle bezeichnet.

Ein direkter Nachteil der bekannten Schaltungsanordnung besteht darin, daß das Ausgangssignal des Mischers mit Hilfe eines Übertragers ausgekoppelt wird, der aufwendig, teuer und nicht integrierbar ist. Bei DC-gekoppelten Eingängen des Mischers zeigt die Schaltungsanordnung eine vergleichsweise große Temperaturabhängigkeit und eine Abhängigkeit von Versorgungsspannungsschwankungen. Darüber hinaus reduzieren statische Mischer-Offsetspannungen den Dynamikbereich der Ausgangsstufe. Die minimale Versorgungsspannung beträgt 4,5V, was für moderne Übertragungssysteme in hochintegrierter Technik, beispielsweise beim Mobilfunk, zu hoch ist.

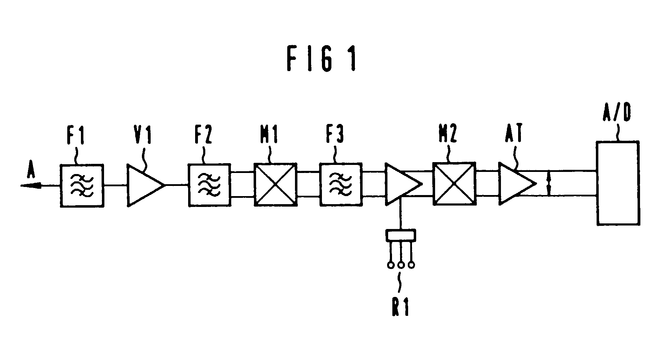

Figur 1 zeigt den Eingangsteil eines drahtlosen Kommunikationsempfängers. Das an der Antenne A empfangene Signal wird über ein Bandpaßfilter F1 einem niedrigrauschenden Verstärker V1 und nach einem weiteren Bandpaßfilter F2 einem ersten Mischer M1 zugeführt. Vom Ausgang des Mischers M1 gelangt das Signal über ein Filter F3 und einen Verstärkungsregler R1 zu einem zweiten Mischer M2, dessen Ausgangssignal über einen Ausgangstreiber AT einem nachgeschalteten Analog/Digital-Wandler A/D zugeführt wird. Das Eingangsignal wird durch eine Doppelüberlagerung mit Hilfe der beiden Mischer auf eine Zwischenfrequenz im Bereich von 10 bis 15 MHz umgesetzt. Auf dieser Zwischenfrequenz erfolgt dann eine Abtastung, das sogenannte IF-Sampling. Die weitere Filterung und die Demodulation, beispielsweise mit einem Quadratur-Demodulator wird dann im Digitalteil beispielsweise mit Hilfe eines digitalen Signalprozessors realisiert.

Die zuvor beschriebene Signalverarbeitung erfordert eine möglichst geringe Abhängigkeit des Zwischenfrequenz-Ausgangssignals von Schwankungen der Betriebsspannung, der Temperatur und von Mischer-Offsetspannungen, die durch statische und dynamische Störgrößen erzeugt werden. Gefordert ist weiterhin ein großer Dynamikbereich. Für die Signalverarbeitung eignet sich deshalb ein bekannter, als Gilbertzelle aufgebauter Mischer nur bedingt oder gar nicht.

Der Erfindung liegt die Aufgabe zugrunde, eine verbesserte Schaltungsanordnung anzugeben.

Diese Aufgabe löst die Erfindung mit den Merkmalen des Patentanspruchs 1.

Die Erfindung hat den Vorteil, daß der Mischer und seine nachgeschaltete Ausgangsstufe in integrierter Ausführung voneinander entkoppelt sind, daß die Abhängigkeiten von der Temperatur und von Versorgungsspannungsschwankungen sehr gering sind, daß die minimale Versorgungsspannung nur noch 2,7V beträgt und daß der Dynamikbereich der Ausgangsstufe von statischen Mischer-Offsetspannungen nicht beeinflußt wird.

Ausgestaltungen der Erfindung sind in Unteransprüchen gekennzeichnet.

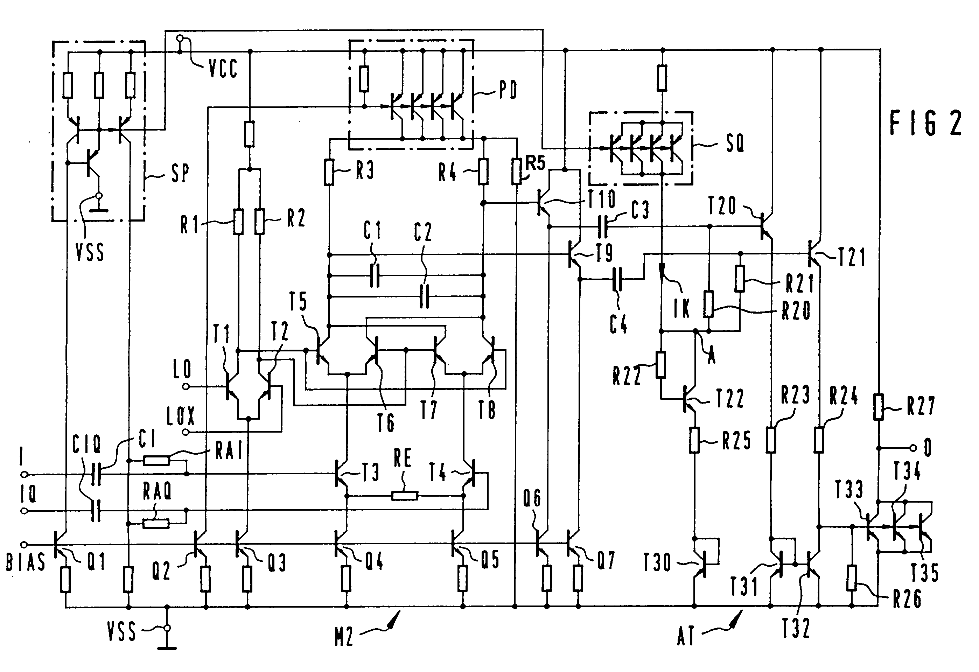

Die Erfindung wird nachfolgend anhand eines in Figur 2 der Zeichnung beschriebenen Ausführungsbeispiels, das eine detaillierte Schaltungsanordnung des Mischers M2 und der Ausgangsstufe AT der Schaltung gemäß Figur 1 zeigt, näher erläutert.

Der Mischer M2 und die Zwischenfrequenz-Ausgangsstufe AT für das IF-Sampling werden von einer Spannung von 2,7V an den Polen VCC und VSS gespeist. Die Schaltung des Mischers M2 wird von einer Reihe Stromquellen Q1 bis Q7, bestehend aus jeweils einem Bipolartransistor und einem Emitterwiderstand, versorgt, wobei die Basisanschlüsse der Transistoren an einer gemeinsamen Klemme Bias geschaltet sind, an der eine Konstantspannung, beispielsweise von einer Bandgap-Stufe liegt. Die Stromquelle Q3 versorgt einen ersten Differenzverstärker aus den emittergekoppelten Transistoren T1 und T2. Das Eingangsignal der Differenzstufe wird über die Klemmen LO und LOQ von einem lokalen Oszillator eingespeist. Das Ausgangssignal der Differenzstufe wird mit Hilfe der Lastwiderstände R1 und R2 in den Kollektorkreisen des Differenzverstärkers erhalten und als ein Eingangsignal in eine Gilbertzelle eingespeist.

Die Gilbertzelle enthält die Transistoren T3 bis T8, wobei die Transistoren T3 und T4 emitterseitig über einen Widerstand RE verbunden sind. Das zu mischende zweite Signal wird über die Klemmen I und IQ als differentielles Signal über jeweils einen Koppelkondensator CI und CIQ in die Basisanschlüsse der Transistoren T3 bzw. T4 eingekoppelt. Der Ausgang des Transistors T3 ist mit den beiden Emittern der Transistoren T5 und T6 verbunden, während der Kollektor des Transistors T4 mit den Emittern von T7 und T8 verbunden ist. Eingangsseitig sind T5 und T8 sowie T6 und T7 jeweils mit einem Ausgang der Differenzstufe aus T1 und T2 verbunden. Ausgangsseitig arbeiten die Kollektoren der Transistoren T5 und T7 auf einen Lastwiderstand R3, während die Kollektoren der Transistoren T6 und T8 gemeinsam auf einen Lastwiderstand R4 arbeiten. Die Verbindungspunkte der Kollektoranschlüsse der Transistoren T5 bis T8 mit dem jeweils zugeordneten Lastwiderstand R3 bzw. R4 bilden den Ausgang der Gilbertzelle, der über Emitterfolger aus den Transistoren T9 bzw. T10 das Signal auskoppelt. Zwischen die Ausgangsanschlüsse der Gilbertzelle, also zwischen die Basisanschlüsse der Transistoren T9 und T10 sind die Kapazitäten C1 und C2 geschaltet, die in Verbindung mit der Gilbertzelle ein Tiefpaßfilter realisieren.

Die Differenzverstärkerstufe aus T1 und T2 sowie die AC-Kopplung mit Hilfe der Kapazitäten CI und CIQ des differentiellen Eingangssignals an den Klemmen I und IQ ermöglicht eine optimale Wahl des Arbeitspunktes der Gilbertzelle, der so eingestellt wird, daß sich an den Lastwiderständen R3 und R4 der größtmögliche Spannungshub ergibt. Dabei wird der DC-Arbeitspunkt der Transistoren T3 und T4 mit Hilfe der Stromquelle Q1 und des Stromspiegels SP sowie der Arbeitspunktwiderstände RA und RAQ eingestellt.

Die Lastwiderstände R3 und R4 der Gilbertzelle sind versorgungsspannungsseitig über eine Anordnung PD, die von der Stromquelle Q2 versorgt wird, an die Klemme VCC geschaltet. Die Anordnung PD kann die Anordnung stromlos schalten. Über einen Widerstand R5 ist die Anordnung PD an den Pol VSS der Versorgungsspannung angeschlossen.

Die Ausgänge der Emitterfolger T9 und T10 sind über Entkoppelkondensatoren C3 und C4, die eine Hochpaßfilterung bewirken, an die Eingänge der Ausgangstreiberstufe AT geschaltet. Der Ausgangstreiber enthält die Transistoren T20 und T21 für die differentiellen Ausgangssignale des Mischers M2. Die Emitter der Transistoren T20 und T21 sind über jeweilige Widerstände R23 und R24 mit einem Stromspiegel aus den Transistoren T31 und T32 verbunden. Der Verbindungspunkt des Widerstands R24 mit dem Transistor T32 ist mit den miteinander verbundenen Basen der Transistoren T33 bis T35 und über einen Widerstand R26 mit dem Bezugspotential VSS verbunden. Die Kollektoranschlüsse der Transistoren T33 bis T35 sind mit der Last R27 verbunden und bilden den Ausgang der Schaltung. Die insoweit beschriebene Treiberstufe übersetzt den Strom durch den Transistor T32 mit der Skalierung aus dem Flächenverhältnis der Transistoren T33 bis T35 zu T32 in den Laststrom, der an der Last R27 einen entsprechenden Spannungsabfall erzeugt. Die Optimierung der AC-gekoppelten Ausgangsstufe AT erfolgt mit Hilfe der Stromquelle SQ, die von der Stromquelle Q1 über den Stromspiegel SP gesteuert wird und einen vorgegebenen, vorzugsweise temperaturkonstanten Strom IK erzeugt. Der Strom IK speist den Knoten A, der über je einen Widerstand R20 bis R22 mit den Basisanschlüssen der Transistoren T20, T21 und T22 des Hilfskreises verbunden ist. Weiterhin ist der Kollektor von T22 mit dem Knoten A verbunden. Emitterseitig ist T22 über einen Widerstand R22 über einen als Diode geschalteten Transistor T30 mit der Klemme VSS verbunden.

Der vom Knoten A ausgehende Strompfad R22, T22, R25 und T30 bildet mit einer identischen Dimensionierung das Verhalten der Strompfade aus R20, T20, R23, T31 sowie R21, T21, R24 und T32 nach. Der in den Knoten A eingespeiste temperaturkonstante Strom IK abzüglich der Basisströme der Transistoren T20 bis T22 stellt den Kollektorstrom durch den Transistor T22 dar. Für die Ausgangsstufe AT ergibt sich somit eine Symmetrierung der Strom- und Spannungsverhältnisse bezüglich des Knotens A, so daß sich in den Transistoren T20 und T21 ebenfalls ein DC-Kollektorstrom entsprechend dem Kollektorstrom von T22 einstellt. Dieser Strom wird dann mit Hilfe des Stromspiegels aus T31 und T32 hochskaliert und in die Ausgangsspannung umgesetzt. Die Symmetrie des Ausgangstreibers AT bezüglich des Knotens A führt zu einem temperaturunabhängigen Verhältnis der Kollektorströme von T20 bis T22. Darüber hinaus werden Versorgungsspannungsänderungen gleichartig auf die Kollektor-Emitter-Spannungen der Transistoren T20 bis T22 abgebildet, was wiederum dazu führt, daß derartige Änderungen nahezu keinen Einfluß auf das Übersetzungsverhältnis der Kollektorströme haben.

Die Tiefpaßfilterung durch die Kondensatoren C1 und C2 am Ausgang der Gilbertzelle in Verbindung mit der Hochpaßfilterung durch die Koppelkondensatoren C3 und C4 am Eingang der Ausgangstreiberstufe AT realisiert eine Bandpaßfilterung des Nutzsignals.

Die beschriebene Schaltungsanordnung gemäß Figur 2 besitzt den Vorteil, daß bei einer minimalen Versorgungsspannung von 2,7V ein großer nutzbarer linearer Aussteuerbereich zur Verfügung steht, daß die Arbeitspunkteinstellung der Treibertransistoren T20 und T21 temperaturkompensiert ist und daß diese Transistoren T20 und T21 eine Kompensation von Versorgungsspannungsschwankungen in der Arbeitspunkteinstellung aufweisen. Gleichzeitig sind der Mischer M2 und der Ausgangstreiber AT DC-mäßig entkoppelt.

Mit Hilfe der erfindungsgemäßen Schaltungsanordnung ist es möglich, die Abhängigkeit der Ausgangsamplitude an der Ausgangsklemme O bezüglich der Temperatur, Versorgungsspannungsschwankungen sowie DC-Offsetspannungen am Mischerausgang, die durch statische oder dynamische Störgrößen erzeugt werden, deutlich zu verringern.

## Patentansprüche

1. Schaltungsanordnung, insbesondere für eine digitale Modulationseinrichtung, mit einer zwei Ausgangsanschlüsse aufweisenden Differenzverstärkerstufe und einer nachgeschalteten, DC-entkoppelten Ausgangsstufe mit zwei Eingangszweigen, bei der die Eingangszweige (T20, R23, T31; T21, R24, T32) der Ausgangsstufe (AT) durch je eine Kapazität (C3, C4) mit den zugeordneten Ausgangsanschlüssen (T9, T10) der Differenzverstärkerstufe (M2) gekoppelt sind und die Ströme durch die Eingangszweige der Ausgangsstufe mit einem Hilfszweig (R22, T22, R25, T30), der von einem vorgegebenen Strom (I_{K}) gespeist wird und der einem der Eingangszweige (R20, T20, R23, T31) entsprechend dimensioniert ist, symmetriert werden,
**dadurch gekennzeichnet,** daß
der Hilfszweig und jeder der Eingangszweige im wesentlichen gleich dimensioniert sind und daß die Eingangszweige Emitterfolger (T20, T21) enthalten, deren Strom mit einem Stromspiegel (T31, T32) in eine Ausgangstransistoranordnung mit Lastelement (T33 bis T35, R27) übersetzt wird.

2. Anordnung nach Anspruch 1,
**dadurch gekennzeichnet,** daß
der Hilfszweig einen Knotenpunkt (A) enthält, der mit dem Kollektor eines Hilfszweigtransistors (T22) und über je einen Widerstand (R20 bis R22) mit jeweils der Basis des Hilfszweigtransistors (T22) und eines Eingangstransistors (T20, T21) der beiden Eingangszweige der Ausgangsstufe verbunden ist und vom vorgegebenen Strom gespeist wird.

3. Anordnung nach Anspruch 1 oder 2,
**dadurch gekennzeichnet,** daß
der vorgegebene Strom ein temperaturunabhängiger Konstantstrom ist.

4. Anordnung nach einem der Ansprüche 1 bis 3,
**dadurch gekennzeichnet,** daß
die Signaleingangszweige (I, IQ) der Differenzverstärkerstufe durch Koppelkapazitäten (CI, CIQ) gleichspannungsmäßig entkoppelt sind.

## Claims

1. Circuit arrangement, in particular for a digital modulation device, having a differential amplifier stage which has two output connections, and having a downstream DC-decoupled output stage having two input paths, in which the input paths (T20, R23, T31; T21, R24, T32) of the output stage (AT) are coupled by means of in each case one capacitance (C3, C4) to the associated output connections (T9, T10) of the differential amplifier stage (M2), and the currents through the input paths of the output stage are balanced by means of an auxiliary path (R22, T22, R25, T30), which is fed by a predetermined current (I_{K}) and is dimensioned corresponding to one of the input paths (R20, T20, R23, T31),
characterized in that,
the auxiliary path and each of the input paths are dimensioned to be essentially the same, and in that the input paths contain emitter followers (T20, T21), whose current is stepped up by means of a balanced circuit (T31, T32) into an output transistor arrangement with a load element (T33 to T35, R27).

2. Arrangement according to Claim 1,
characterized in that,
the auxiliary path contains a node point (A), which is connected to the collector of an auxiliary path transistor (T22) and, via in each case one resistor (R20 to R22), respectively to the base of the auxiliary path transistor (T22) and of an input transistor (T20, T21) in the two input paths of the output stage, and is fed with the predetermined current.

3. Arrangement according to Claim 1 or 2,
characterized in that,
the predetermined current is a constant current, independent of temperature.

4. Arrangement according to one of Claims 1 to 3,
characterized in that,
the signal input paths (I, IQ) of the differential amplifier stage are DC-coupled by means of coupling capacitances (CI, CIQ).

## Revendications

1. Montage, notamment pour un dispositif de modulation numérique, comportant un étage amplificateur différentiel ayant deux bornes de sortie et un étage de sortie en aval, découplé du point de vue du courant continu et ayant deux branches d'entrée, dans lequel les branches (T20, R23, T31 ; T21, R24, T32) d'entrée de l'étage (AT) de sortie sont couplées chacune par une capacité (C3, C4) aux bornes (T9, T10) de sortie associées de l'étage (M2) amplificateur différentiel et dans lequel les courants passant dans les branches d'entrée de l'étage de sortie sont équilibrés par une branche (R22, T22, R25, T30) auxiliaire qui est alimentée en un courant (I_{K}) prescrit et qui est dimensionné de manière correspondant à une des branches (R20, T20, R23, T31) d'entrée,
caractérisé en ce que
la branche auxiliaire et chacune des branches d'entrée sont dimensionnées sensiblement de la même manière et en ce que les branches d'entrée contiennent des suiveurs (T20, T21) d'émetteurs dont le courant est envoyé dans un dispositif de transistors de sortie à élément de charge (T33 à T35, R27).

2. Dispositif suivant la revendication 1, caractérisé en ce que la branche auxiliaire contient un point (A) nodal qui est relié au collecteur d'un transistor (T22) de branche auxiliaire et, par l'intermédiaire chaque fois d'une résistance (R20 à R22), à la base du transistor (T22) de branche auxiliaire et d'un transistor (T20, T21) d'entrée des deux branches d'entrée de l'étage de sortie et qui est alimenté en le courant prescrit.

3. Dispositif suivant la revendication 1 ou 2, caractérisé en ce que le courant prescrit est un courant constant indépendant de la température.

4. Dispositif suivant l'une des revendications 1 à 3, caractérisé en ce que les branches (I, IQ) d'entrée de signaux de l'étage amplificateur différentiel sont découplées du point de vue de la tension continue par des capacités (Cl, CIQ) de couplage.
